# EUROPEAN PATENT APPLICATION

(11) **EP 4 535 013 A1**
(43) Date of publication of application: **09.04.2025**
(21) Application number: 22943795.9
(22) Date of filing: 27.05.2022
(51) Int. Cl.: G01R 31/12

(54) **PARTIAL DISCHARGE MONITORING DEVICE FOR GAS INSULATED SWITCHGEAR**

(71) Applicant: MITSUBISHI ELECTRIC CORPORATION, Chiyoda-ku Tokyo 100-8310 (JP)
(72) Inventor: ABE Junichi, Tokyo 100-8310 (JP); MATSUYAMA Kotaro, Tokyo 100-8310 (JP); OTAKE Yasutomo, Tokyo 100-8310 (JP)
(74) Representative: Witte, Weller & Partner Patentanwälte mbB
(86) International application number: PCT/JP2022/021669
(87) International publication number: WO 2023/228395

(57) **Abstract**

Provided is a partial discharge monitoring device that can determine an occurrence factor of a partial discharge. A partial discharge monitoring device (10) for a gas insulated switchgear (1) connected to an external device via an insulated adapter (4) and an insulated bus bar (5) includes: a voltage detector (7), connected between an outer-surface ground layer of insulated adapter (43) and an outer-surface ground layer of insulated bus bar (53), which detects a voltage pulse due to a partial discharge and a phase of a grid voltage; and a partial discharge analyzer (8). The partial discharge analyzer includes: a partial discharge occurrence position determination unit which determines an occurrence position of the partial discharge; and a partial discharge occurrence factor determination unit which determines, based on a shape of a ϕ-q-n pattern of the partial discharge and the occurrence position of the partial discharge, an occurrence factor of the partial discharge.

## Description

### TECHNICAL FIELD

The present disclosure relates to a partial discharge monitoring device for a gas insulated switchgear.

### BACKGROUND ART

There has been a cubicle-type gas insulated switchgear as power receiving/distributing equipment installed in a substation, a factory, a building, or the like. In the gas insulated switchgear, a device such as a circuit breaker or a disconnector is accommodated in a sealed container made of a metal, and the inside of the sealed container is filled with an insulating gas. When the insulation performance in the gas insulated switchgear is decreased at the time of running thereof owing to leakage of the insulating gas, degradation of a solid insulated part composing the device, metal as foreign matter generated in association with operation of the device, or the like, the gas insulated switchgear might suffer local dielectric breakdown, resulting in a partial discharge. The partial discharge is a precursor of a failure, and thus execution of monitoring to detect such a partial discharge makes it possible to prevent a failure of the gas insulated switchgear.

In a conventional partial discharge monitoring device for a gas insulated switchgear, an insulating material is molded on a main circuit device, and a ground layer is provided on the outer surface of the insulating material on the main circuit device. The partial discharge monitoring device measures current flowing between the ground layer and a ground potential, to detect a partial discharge. At this time, the partial discharge monitoring device determines the occurrence position of the partial discharge on the basis of the direction of the flow of the current (see, for example, Patent Document 1).

### CITATION LIST

### PATENT DOCUMENT

Patent Document 1: Japanese Laid-Open Patent Publication No. 2009-168489

### SUMMARY OF THE INVENTION

### PROBLEM TO BE SOLVED BY THE INVENTION

However, although the conventional partial discharge monitoring device for the gas insulated switchgear can determine the occurrence position of the partial discharge, a problem arises in that the conventional partial discharge monitoring device cannot determine an occurrence factor of the partial discharge.

The present disclosure has been made to solve the above problem, and an object of the present disclosure is to provide a partial discharge monitoring device, for a gas insulated switchgear, that can determine an occurrence factor of a partial discharge.

### MEANS TO SOLVE THE PROBLEM

A partial discharge monitoring device for a gas insulated switchgear according to the present disclosure is a partial discharge monitoring device for a gas insulated switchgear connected to an external device via an insulated adapter and an insulated bus bar, the partial discharge monitoring device including: a voltage detector which is connected between an outer-surface ground layer of the insulated adapter and an outer-surface ground layer of the insulated bus bar and which detects a voltage pulse due to a partial discharge and a phase of a grid voltage of the gas insulated switchgear; and a partial discharge analyzer which performs partial discharge analysis on the basis of the voltage pulse detected by the voltage detector. The partial discharge analyzer includes: a partial discharge occurrence position determination unit which determines an occurrence position of the partial discharge on the basis of a polarity of the voltage pulse; and a partial discharge occurrence factor determination unit which determines an occurrence factor of the partial discharge on the basis of a shape of a ϕ-q-n pattern of the partial discharge and the occurrence position of the partial discharge determined by the partial discharge occurrence position determination unit, where ϕ represents the phase of the grid voltage at a timing of occurrence of the voltage pulse, q represents an intensity of the voltage pulse, and n represents an occurrence frequency of the voltage pulse.

### EFFECT OF THE INVENTION

The partial discharge monitoring device for the gas insulated switchgear according to the present disclosure includes the partial discharge occurrence factor determination unit which determines an occurrence factor of the partial discharge on the basis of the shape of the ϕ-q-n pattern of the partial discharge and the occurrence position of the partial discharge determined by the partial discharge occurrence position determination unit. Consequently, an occurrence factor of the partial discharge can be determined.

### BRIEF DESCRIPTION OF THE DRAWINGS

[FIG. 1] FIG. 1 is a configuration diagram of a partial discharge monitoring device for a gas insulated switchgear according to embodiment 1.
[FIG. 2] FIG. 2 is a configuration diagram of a partial discharge analyzer according to embodiment 1.
[FIG. 3] FIG. 3 is a diagram for explaining the relationship between the occurrence position of, and the polarity of a voltage pulse due to, a partial discharge in the gas insulated switchgear according to embodiment 1.
[FIG. 4] FIG. 4 is a diagram for explaining the relationship between the occurrence position of, and the polarity of a voltage pulse due to, a partial discharge in the gas insulated switchgear according to embodiment 1.
[FIG. 5] FIG. 5 is a diagram for explaining the shapes of ϕ-q-n patterns of partial discharges, according to the gas insulated switchgear according to embodiment 1.
[FIG. 6] FIG. 6 is a diagram for explaining the shapes of ϕ-q-n patterns of partial discharges, according to the gas insulated switchgear according to embodiment 1.
[FIG. 7] FIG. 7 is a diagram for explaining the shapes of ϕ-q-n patterns of partial discharges, according to the gas insulated switchgear according to embodiment 1.
[FIG. 8] FIG. 8 is a diagram for explaining the shape of a ϕ-q-n pattern of a partial discharge in the gas insulated switchgear according to embodiment 1.
[FIG. 9] FIG. 9 is a flowchart showing a method for determining an occurrence factor of a partial discharge by a partial discharge occurrence factor determination unit according to embodiment 1.
[FIG. 10] FIG. 10 is a configuration diagram of a partial discharge monitoring device for a gas insulated switchgear according to embodiment 3.
[FIG. 11] FIG. 11 shows a hardware configuration for realizing a partial discharge occurrence determination unit, a partial discharge occurrence position determination unit, and the partial discharge occurrence factor determination unit according to each of embodiments 1 to 3.

### DESCRIPTION OF EMBODIMENTS

Hereinafter, partial discharge monitoring devices for gas insulated switchgears according to embodiments for carrying out the present disclosure will be described in detail with reference to the drawings. The same or corresponding constituents in the drawings are denoted by the same reference characters.

### Embodiment 1

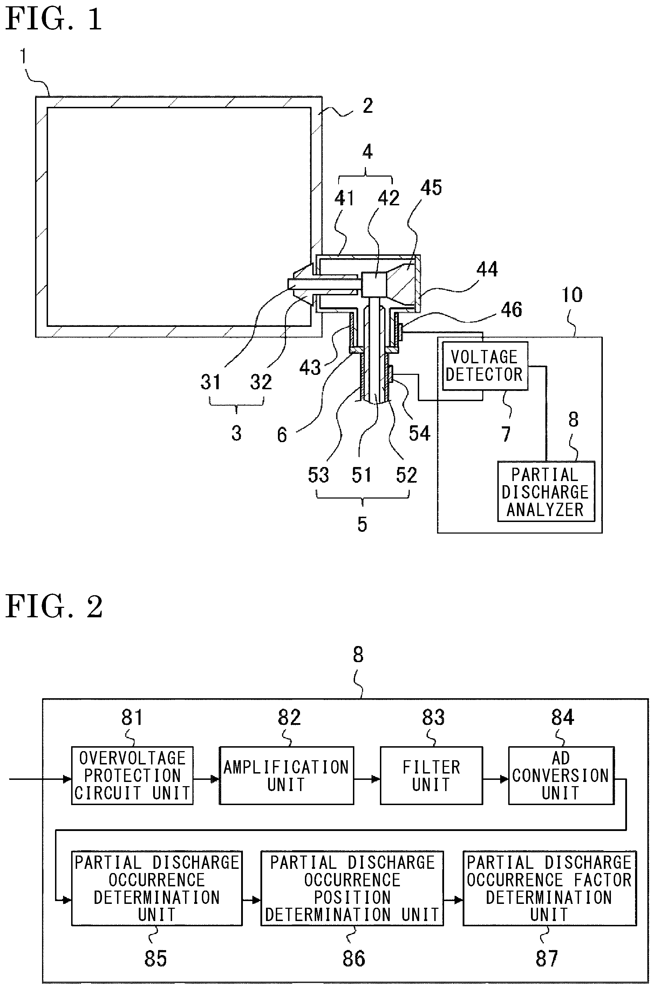

FIG. 1 is a configuration diagram of a partial discharge monitoring device for a gas insulated switchgear according to embodiment 1. A gas insulated switchgear 1 in the present embodiment has a metal container 2 in which a circuit breaker, a disconnector, or the like (none of which is shown) is accommodated. The inside of the metal container 2 is filled with, for example, an insulating gas such as sulfur hexafluoride (SF₆). The gas insulated switchgear 1 is electrically connected to an external transformer or the like (not shown) via a bushing 3, an insulated adapter 4, and an insulated bus bar 5. The voltage applied to the gas insulated switchgear 1 is referred to as grid voltage. The insulated bus bar mentioned herein is a bus bar, as a conductor, that has an insulated periphery. A bus bar having a periphery insulated with an insulating gas is referred to as gas insulated bus bar, and a bus bar having a periphery coated with a solid insulating material such as silicone rubber is referred to as solid insulated bus bar.

The bushing 3 is composed of a center conductor 31 and an insulating member 32 coating the outer periphery of the center conductor 31. The bushing 3 is inserted in the metal container 2 so as to maintain airtightness. A portion, of the center conductor 31, that is located in the metal container 2 is electrically connected to the circuit breaker, the disconnector, or the like accommodated in the metal container 2.

The insulated adapter 4 has an insulating container 41 and a contactor 42. An outer-surface ground layer of insulated adapter 43 is provided on the outer side of the insulating container 41. The outer-surface ground layer of insulated adapter 43 is set to be at a ground potential. A portion, of the bushing 3, that is exposed from the metal container 2 is inserted in the insulated adapter 4. The insulated adapter 4 has an electrically-conductive cover 44 provided on a side opposite to the side on which the bushing 3 is inserted. The contactor 42 is connected to the bushing 3 and the insulated bus bar 5. The electrically-conductive cover 44 and an insulating member 45 provided on the inner side thereof are inserted in and fixed to the insulated adapter 4 after the contactor 42 is disposed.

The insulated bus bar 5 has: a center conductor 51; an insulating member 52 coating the outer periphery of the center conductor 51; and an outer-surface ground layer of insulated bus bar 53 coating the outer periphery of the insulating member 52. The outer-surface ground layer of insulated bus bar 53 is set to be at the ground potential. The insulated bus bar 5 is inserted in the insulated adapter 4. An insulating tube 6 is provided between the insulated bus bar 5 and the insulated adapter 4. The outer-surface ground layer of insulated adapter 43 and the outer-surface ground layer of insulated bus bar 53 are electrically insulated from each other by the insulating tube 6. The center conductor 31 of the bushing 3 inserted in the insulated adapter 4 and one end portion of the center conductor 51 of the insulated bus bar 5 inserted in the insulated adapter 4 are electrically connected to each other by the contactor 42. Another end portion of the center conductor 51 of the insulated bus bar 5 is electrically connected to, for example, an external device such as a transformer.

An insulated adapter ground terminal 46 is provided on a portion of the outer-surface ground layer of insulated adapter 43. In addition, an insulated bus bar ground terminal 54 is provided on a portion of the outer-surface ground layer of insulated bus bar 53. A voltage detector 7 is connected between the insulated adapter ground terminal 46 and the insulated bus bar ground terminal 54. When a partial discharge occurs in the gas insulated switchgear 1 or the external device connected thereto, a voltage pulse is generated between the insulated adapter ground terminal 46 and the insulated bus bar ground terminal 54. The voltage detector 7 can detect the voltage pulse due to the partial discharge. In addition, the voltage detector 7 can measure the phase of the grid voltage by measuring a voltage based on an induced current that flows, as a result of induction by the grid voltage, between the insulated adapter ground terminal 46 and the insulated bus bar ground terminal 54.

A partial discharge analyzer 8 is connected to the voltage detector 7. The partial discharge analyzer 8 receives the voltage pulse due to the partial discharge and the phase of the grid voltage which have been detected by the voltage detector 7. As the voltage detector 7, for example, a voltage probe may be used. The partial discharge analyzer 8 analyzes the received voltage pulse, thereby being able to determine: whether or not a partial discharge has occurred; an occurrence position of the partial discharge; and an occurrence factor of the partial discharge. A partial discharge monitoring device 10 for the gas insulated switchgear according to the present embodiment is composed of the voltage detector 7 and the partial discharge analyzer 8.

FIG. 2 is a configuration diagram of the partial discharge analyzer in the present embodiment. The partial discharge analyzer 8 in the present embodiment includes an overvoltage protection circuit unit 81, an amplification unit 82, a filter unit 83, an analog-digital conversion unit (hereinafter, written as AD conversion unit) 84, a partial discharge occurrence determination unit 85, a partial discharge occurrence position determination unit 86, and a partial discharge occurrence factor determination unit 87. The overvoltage protection circuit unit 81 eliminates an overvoltage component included in the voltage pulse received from the voltage detector 7. The amplification unit 82 amplifies the voltage pulse from which the overvoltage component has been eliminated. The filter unit 83 eliminates a noise component that is included in the voltage pulse and that has a frequency different from the frequency of the grid voltage. The AD conversion unit 84 converts the voltage pulse from which the noise component has been eliminated, from an analog voltage pulse into a digital voltage pulse. The partial discharge occurrence determination unit 85, the partial discharge occurrence position determination unit 86, and the partial discharge occurrence factor determination unit 87 analyze the digitized voltage pulse, to determine: whether or not a partial discharge has occurred; an occurrence position of the partial discharge; and an occurrence factor of the partial discharge.

The partial discharge occurrence determination unit 85 determines, when the intensity of the voltage pulse is equal to or higher than a preset threshold value, that a partial discharge has occurred. The overvoltage protection circuit unit 81, the amplification unit 82, the filter unit 83, the AD conversion unit 84, and the partial discharge occurrence determination unit 85 may be provided to the voltage detector 7 instead of the partial discharge analyzer 8.

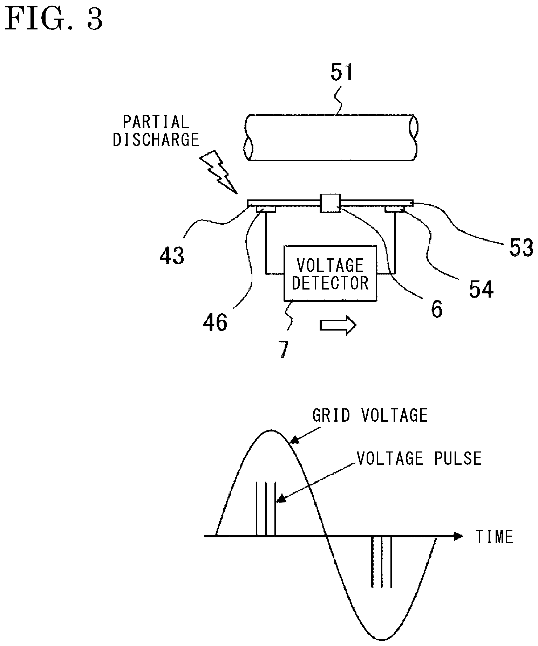

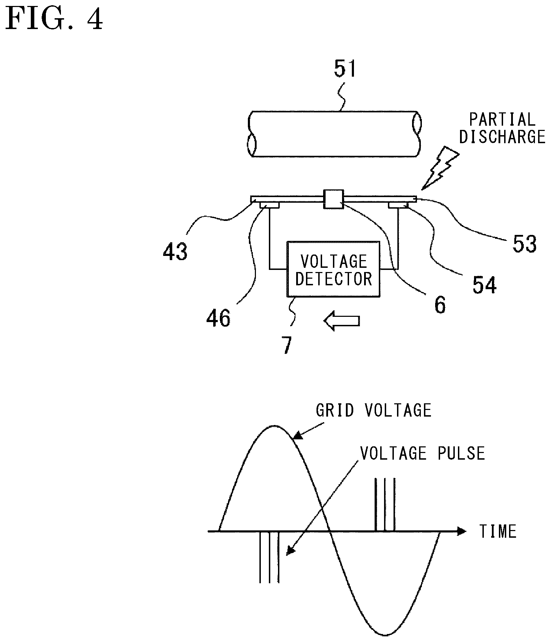

Each of FIG. 3 and FIG. 4 is a diagram for explaining the relationship between the occurrence position of, and the polarity of a voltage pulse due to, a partial discharge in the gas insulated switchgear in the present embodiment. As shown on the upper side of FIG. 3, when a partial discharge occurs on the left side, i.e., the insulated adapter 4 side, relative to the insulating tube 6, current flows through the voltage detector 7 from the outer-surface ground layer of insulated adapter 43 toward the outer-surface ground layer of insulated bus bar 53 as indicated by the white arrow. At this time, as shown on the lower side of FIG. 3, voltage pulses each having the same polarity as the polarity, at the corresponding voltage phase, of the grid voltage applied to the center conductor 51 are detected. Meanwhile, as shown on the upper side of FIG. 4, when a partial discharge occurs on the right side, i.e., the insulated bus bar 5 side, relative to the insulating tube 6, current flows through the voltage detector 7 from the outer-surface ground layer of insulated bus bar 53 toward the outer-surface ground layer of insulated adapter 43 as indicated by the white arrow. At this time, as shown on the lower side of FIG. 4, voltage pulses each having a polarity opposite to the polarity, at the corresponding voltage phase, of the grid voltage applied to the center conductor 51 are detected. Hereinafter, a voltage pulse due to a partial discharge is simply expressed as the pulse of the partial discharge.

The partial discharge occurrence position determination unit 86 performs frequency analysis to extract, from a signal of the voltage pulse, a component having a frequency that matches the frequency of the grid voltage. Then, the partial discharge occurrence position determination unit 86 ascertains the polarity of the grid voltage at a timing of occurrence of the partial discharge. Examples of a method for the frequency analysis include the fast Fourier transform (FFT) method. Likewise, the partial discharge occurrence position determination unit 86 performs frequency analysis to extract the pulse of the partial discharge, and then, ascertains the polarity of the pulse of the partial discharge. The partial discharge occurrence position determination unit 86 determines, on the basis of the polarity of the grid voltage and the polarity of the pulse of the partial discharge, whether the occurrence position of the partial discharge is on the insulated adapter 4 side or the insulated bus bar 5 side relative to the insulating tube 6.

The partial discharge occurrence factor determination unit 87 determines an occurrence factor of the partial discharge on the basis of: the phase of the grid voltage at the timing of occurrence of the partial discharge, the polarity of the pulse of the partial discharge, the intensity of the pulse of the partial discharge, and the occurrence frequency of the pulse of the partial discharge, the grid voltage and the pulse of the partial discharge having been extracted through frequency analysis by the partial discharge occurrence position determination unit 86; and the occurrence position of the partial discharge determined by the partial discharge occurrence position determination unit 86.

Next, a method for determining an occurrence factor of the partial discharge by the partial discharge occurrence factor determination unit 87 will be described.

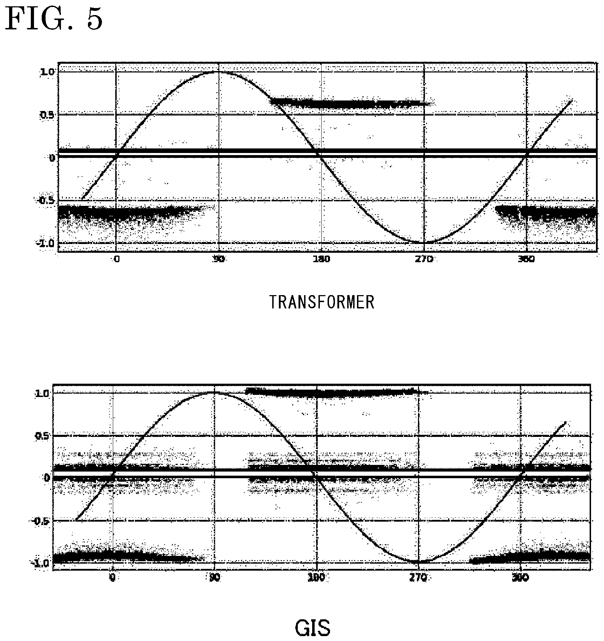

An occurrence characteristic of a partial discharge is correlated with an occurrence factor of the partial discharge. The intensity of the pulse of the partial discharge is defined as q, the occurrence frequency of the pulse is defined as n, and the phase of the grid voltage at the timing of occurrence of the pulse of the partial discharge is defined as ϕ. An occurrence factor of the partial discharge can be determined according to the shape of a ϕ-q-n pattern. FIG. 5 to FIG. 8 are diagrams for explaining the shapes of ϕ-q-n patterns of partial discharges. In each of FIG. 5 to FIG. 8, the horizontal axis indicates the phase ϕ of the grid voltage, and the vertical axis indicates voltage. In each of FIG. 5 to FIG. 8, the sine waves each indicate the waveform of the grid voltage, and the black dots indicate the occurrence frequency n of the partial discharge. That is, the ϕ-q-n patterns of the partial discharges in FIG. 5 to FIG. 8 are each based on: the position on the horizontal axis of each of the black dots, the position corresponding to the phase ϕ of the grid voltage at the time of occurrence of the partial discharge; the position on the vertical axis of the black dot, the position corresponding to the intensity q; and the darkness/paleness of the black dots, the darkness/paleness corresponding to the occurrence frequency n. The ϕ-q-n pattern of the partial discharge can be obtained from the phase of the grid voltage at the timing of occurrence of the partial discharge, the intensity of the pulse of the partial discharge, and the occurrence frequency of the pulse of the partial discharge, the grid voltage and the pulse of the partial discharge having been extracted by the partial discharge occurrence position determination unit 86.

Here, in the waveform of the grid voltage shown in FIG. 5 to FIG. 8, each of the positions of the maximum value and the minimum value of the waveform is referred to as peak, and each of the positions, on the waveform, at which the voltage is zero is referred to as zero-crossing position. The characteristics shown in FIG. 5 to FIG. 8 indicate characteristics in a case where occurrence factors of partial discharges are known in advance.

The shapes of the ϕ-q-n patterns of the respective partial discharges shown in FIG. 5 to FIG. 8 will be described. In the following description, a transformer is assumed to be connected to the gas insulated switchgear 1 in the present embodiment via the insulated bus bar 5. In the transformer, mineral oil is used as an insulating oil. In the present embodiment, a partial discharge in the gas insulated switchgear 1 occurs in the SF₆ with which the inside of the metal container 2 is filled. Meanwhile, a partial discharge in the transformer occurs in the mineral oil. Hereinafter, the gas insulated switchgear is written as GIS.

The occurrence factor of the partial discharge is classified into four factors which are floating electrode, conductor protrusion, surface foreign matter, and insulating member internal gap. The floating electrode refers to, for example, a state where a metal member such as a bolt used for fixing a conductor in the GIS is at a floating potential without being conductive to the conductor. The conductor protrusion refers to a state where a protrusion is present on the surface of a conductor such as an electrode or a center conductor. The surface foreign matter refers to a state where foreign matter is adhered on the surface of an insulating member. The insulating member internal gap refers to a state where a gap is present in an insulating member. When any of the states occurs, electrical fields are concentrated on the corresponding portion from which a partial discharge originates. As shown in FIG. 5 to FIG. 8, the ϕ-q-n pattern of the partial discharge differs depending on the occurrence factor of the partial discharge.

FIG. 5 shows the shapes of ϕ-q-n patterns of partial discharges in a case where the occurrence factor of the partial discharge is the floating electrode. The floating electrode occurs in both the transformer and the GIS. As shown on the upper side of FIG. 5, when the floating electrode occurs in the transformer, partial discharges having a fixed intensity occur in the vicinity of each of the zero-crossing positions. At the same time, noises having low intensities occur regardless of the relationship with the phase of the grid voltage. As shown on the lower side of FIG. 5, when the floating electrode occurs in the GIS, partial discharges having a fixed intensity occur in the vicinity of each of the zero-crossing positions. At the same time, partial discharges having low intensities occur in the vicinity of each of the zero-crossing positions. When the floating electrode occurs, there is no significant difference between the ϕ-q-n patterns of the partial discharges that have occurred in the transformer and the GIS and that exclude partial discharges having low intensities, and a pattern shape with a wide distribution about the zero-crossing positions at a fixed intensity is obtained. This pattern shape is referred to as the shape of a "floating cloud" (hereinafter, simply referred to as "floating cloud").

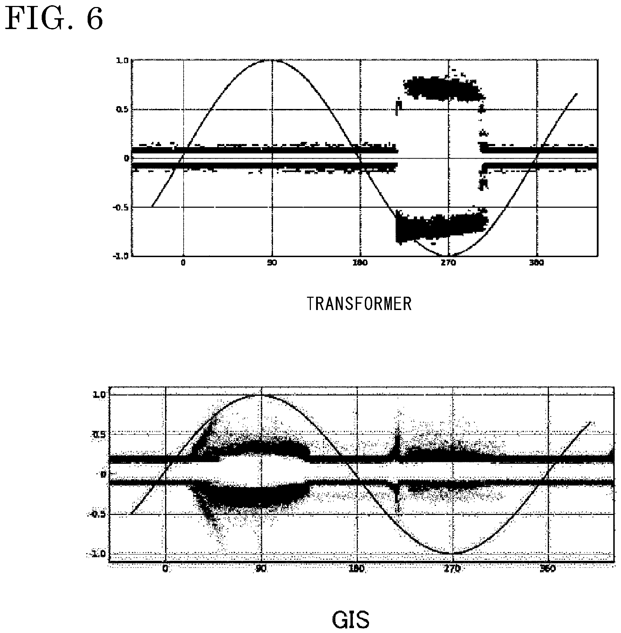

FIG. 6 shows the shapes of ϕ-q-n patterns of partial discharges in a case where the occurrence factor of the partial discharge is the conductor protrusion. The conductor protrusion occurs in both the transformer and the GIS. As shown on the upper side of FIG. 6, when the conductor protrusion occurs in the transformer, partial discharges having a fixed intensity occur in the vicinity of the negative peak of the grid voltage. At the same time, noises having low intensities occur regardless of the relationship with the phase of the grid voltage. As shown on the lower side of FIG. 6, when the conductor protrusion occurs in the GIS, a partial discharge occurs such that: the intensity of the partial discharge rises according to changes in the grid voltage, subsequently to each of the zero-crossing positions; and then the intensity of the partial discharge varies in the vicinity of the corresponding peak. At the same time, noises having low intensities occur regardless of the relationship with the phase of the grid voltage. The ϕ-q-n pattern (shown on the upper side of FIG. 6) of the partial discharge that has occurred in the transformer and that excludes partial discharges having low intensities, has a pattern shape with a wide distribution about the peak. This pattern shape is also a pattern shape that can be called "floating cloud". Meanwhile, the ϕ-q-n pattern (shown on the lower side of FIG. 6) of the partial discharge that has occurred in the GIS and that excludes partial discharges having low intensities, has a pattern shape in which: the intensity of the partial discharge rises subsequently to each of the zero-crossing positions; and then the intensity varies in the vicinity of the corresponding peak. This pattern shape is referred to as the shape of a "rabbit" (hereinafter, simply referred to as "rabbit").

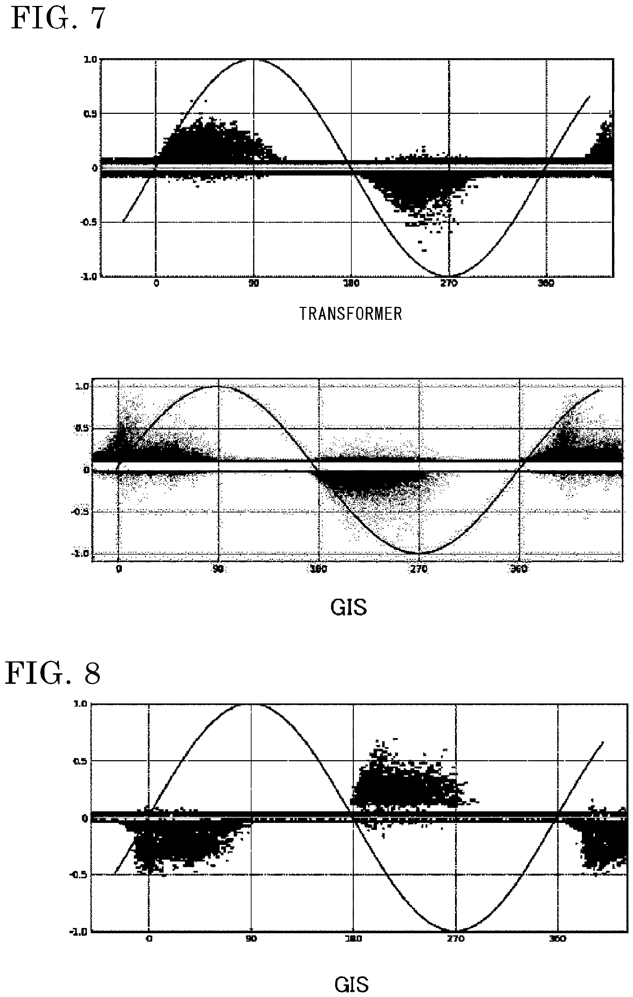

FIG. 7 shows the shapes of ϕ-q-n patterns of partial discharges in a case where the occurrence factor of the partial discharge is the surface foreign matter. The surface foreign matter occurs in both the transformer and the GIS. As shown on the upper side of FIG. 7, when the surface foreign matter occurs in the transformer, a partial discharge occurs such that the intensity thereof varies between each of the zero-crossing positions and the corresponding peak. At the same time, noises having low intensities occur regardless of the relationship with the phase of the grid voltage. As shown on the lower side of FIG. 7, when the surface foreign matter occurs in the GIS, a partial discharge occurs such that: the intensity thereof rises in the vicinity of each of the zero-crossing positions; and then the intensity varies until arrival at the vicinity of the corresponding peak. At the same time, noises having low intensities occur regardless of the relationship with the phase of the grid voltage. When the surface foreign matter occurs in the transformer, a pattern is obtained in which the intensity varies between each of the zero-crossing positions and the corresponding peak. This pattern shape is referred to as the shape of a "turtle" (hereinafter, simply referred to as "turtle"). When the surface foreign matter occurs in the GIS, a partial discharge occurs such that: the intensity thereof rises in the vicinity of each of the zero-crossing positions; and then the intensity varies until arrival at the vicinity of the corresponding peak. This pattern shape differs from "turtle" and is a pattern shape that can be called "rabbit".

FIG. 8 shows the shape of a ϕ-q-n pattern of a partial discharge in a case where the occurrence factor of the partial discharge is the insulating member internal gap. The insulating member internal gap occurs only in the GIS. As shown in FIG. 8, when there is a gap in the insulating member of the GIS, a partial discharge occurs such that the intensity thereof varies between each of the zero-crossing positions and the corresponding peak. At the same time, noises having low intensities occur regardless of the relationship with the phase of the grid voltage. The ϕ-q-n pattern in a case where there is a gap in the insulating member with exclusion of partial discharges having low intensities, has a pattern shape in which the intensity varies between each of the zero-crossing positions and the corresponding peak. This pattern shape is a pattern shape that can be called "turtle".

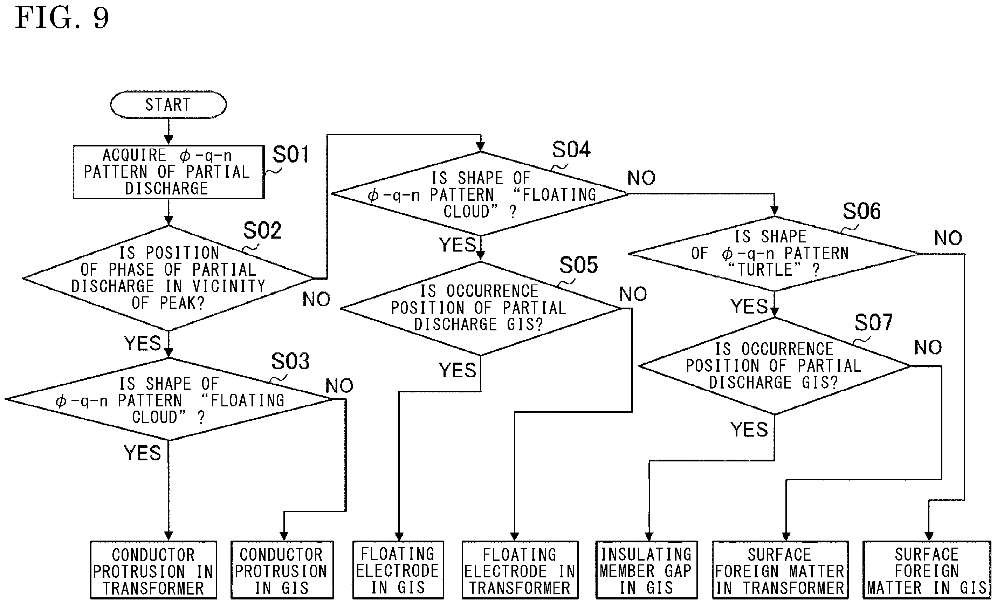

FIG. 9 is a flowchart showing a method for determining an occurrence factor of the partial discharge by the partial discharge occurrence factor determination unit 87. The partial discharge occurrence factor determination unit 87 determines an occurrence factor of the partial discharge on the basis of: the relationship with the phase of the grid voltage at the time of occurrence of the partial discharge; the shape of the ϕ-q-n pattern; and the occurrence position of the partial discharge.

In step S01, the partial discharge occurrence factor determination unit 87 acquires a ϕ-q-n pattern obtained by the partial discharge occurrence position determination unit 86. In step S02, the partial discharge occurrence factor determination unit 87 determines whether or not the position of the phase of the partial discharge is in the vicinity of a peak. When it is determined in step S02 that the position of the phase of the partial discharge is in the vicinity of a peak (YES), the partial discharge occurrence factor determination unit 87 advances the process to step S03. In step S03, the partial discharge occurrence factor determination unit 87 analyzes the ϕ-q-n pattern and determines whether or not the shape of the ϕ-q-n pattern is "floating cloud". When it is determined in step S03 that the shape of the ϕ-q-n pattern is "floating cloud" (YES), the partial discharge occurrence factor determination unit 87 determines that the occurrence factor of the partial discharge is the conductor protrusion in the transformer. Meanwhile, when it is determined in step S03 that the shape of the ϕ-q-n pattern is not "floating cloud" (NO), the partial discharge occurrence factor determination unit 87 determines that the occurrence factor of the partial discharge is the conductor protrusion in the GIS.

When it is determined in step S02 that the position of the phase of the partial discharge is not in the vicinity of a peak (NO), the partial discharge occurrence factor determination unit 87 advances the process to step S04. In step S04, the partial discharge occurrence factor determination unit 87 analyzes the ϕ-q-n pattern and determines whether or not the shape of the ϕ-q-n pattern is "floating cloud". When it is determined in step S04 that the shape of the ϕ-q-n pattern is "floating cloud" (YES), the partial discharge occurrence factor determination unit 87 advances the process to step S05. In step S05, the partial discharge occurrence factor determination unit 87 determines whether or not the occurrence position of the partial discharge is on the GIS side. Here, the case where the occurrence position of the discharge is on the GIS side is a case where the occurrence position of the partial discharge determined by the partial discharge occurrence position determination unit 86 is on the insulated adapter 4 side relative to the insulating tube 6. In contrast, in a case where the occurrence position of the partial discharge determined by the partial discharge occurrence position determination unit 86 is on the insulated bus bar 5 side relative to the insulating tube 6, the occurrence position of the discharge is regarded as being on the transformer side. When it is determined in step S05 that the occurrence position of the partial discharge is on the GIS side (YES), the partial discharge occurrence factor determination unit 87 determines that the occurrence factor of the partial discharge is the floating electrode in the GIS. Meanwhile, when it is determined in step S05 that the occurrence position of the partial discharge is not on the GIS side (NO), the partial discharge occurrence factor determination unit 87 determines that the occurrence factor of the partial discharge is the floating electrode in the transformer.

When it is determined in step S04 that the shape of the ϕ-q-n pattern is not "floating cloud" (NO), the partial discharge occurrence factor determination unit 87 advances the process to step S06. In step S06, the partial discharge occurrence factor determination unit 87 analyzes the ϕ-q-n pattern and determines whether or not the shape of the ϕ-q-n pattern is "turtle". When it is determined in step S06 that the shape of the ϕ-q-n pattern is "turtle" (YES), the partial discharge occurrence factor determination unit 87 advances the process to step S07. In step S07, the partial discharge occurrence factor determination unit 87 determines whether or not the occurrence position of the partial discharge is on the GIS side. When it is determined in step S07 that the occurrence position of the partial discharge is on the GIS side (YES), the partial discharge occurrence factor determination unit 87 determines that the occurrence factor of the partial discharge is the insulating member gap in the GIS. Meanwhile, when it is determined in step S07 that the occurrence position of the partial discharge is not on the GIS side (NO), the partial discharge occurrence factor determination unit 87 determines that the occurrence factor of the partial discharge is the surface foreign matter in the transformer.

When it is determined in step S06 that the shape of the ϕ-q-n pattern is not "turtle" (NO), the partial discharge occurrence factor determination unit 87 determines that the occurrence factor of the partial discharge is the surface foreign matter in the GIS.

The determination as to whether or not the shape of the ϕ-q-n pattern of the partial discharge is "floating cloud" or the determination as to whether or not the shape of the ϕ-q-n pattern of the partial discharge is "turtle" which are shown in the flowchart in FIG. 9 can be performed with use of an artificial intelligence technology (AI technology) by recognizing, as image shapes, the shapes of the ϕ-q-n patterns of the partial discharges shown in FIG. 5 to FIG. 8. Specifically, it is possible to perform the determination with use of a correlation coefficient or a machine learning algorithm such as a convolutional neural network (CNN) or a support vector machine (SVM).

In the partial discharge monitoring device for the gas insulated switchgear which is thus configured, an occurrence factor of a partial discharge can be determined by using the shape of the ϕ-q-n pattern of the partial discharge at the time of occurrence of the partial discharge and the occurrence position of the partial discharge.

### Embodiment 2

For a gas insulated switchgear according to embodiment 2, an instrument current transformer (CT) is used as the voltage detector 7 of the partial discharge monitoring device for the gas insulated switchgear described in embodiment 1. A partial discharge monitoring device for the gas insulated switchgear according to the present embodiment has the same configuration as the configuration of the partial discharge monitoring device for the gas insulated switchgear described in embodiment 1, except for the configuration of the voltage detector 7. The instrument current transformer is composed of: a primary coil, on an input side, which detects a voltage; a secondary coil on an output side; and a core magnetically coupling the primary coil and the secondary coil. The primary coil and the secondary coil are electrically insulated from each other.

In the partial discharge monitoring device for the gas insulated switchgear according to the present embodiment, an occurrence factor of a partial discharge can be determined by using the ϕ-q-n pattern of the partial discharge and the occurrence position of the partial discharge in the same manner as in the partial discharge monitoring device for the gas insulated switchgear according to embodiment 1. In addition, since the instrument current transformer is used as the voltage detector 7, the accuracy of measurement can be made higher than in voltage measurement performed with the voltage probe being connected between the insulated adapter ground terminal 46 and the insulated bus bar ground terminal 54. This is because the instrument current transformer is easily set so as to inflict little influence of a measuring instrument impedance on a to-be-measured system.

### Embodiment 3

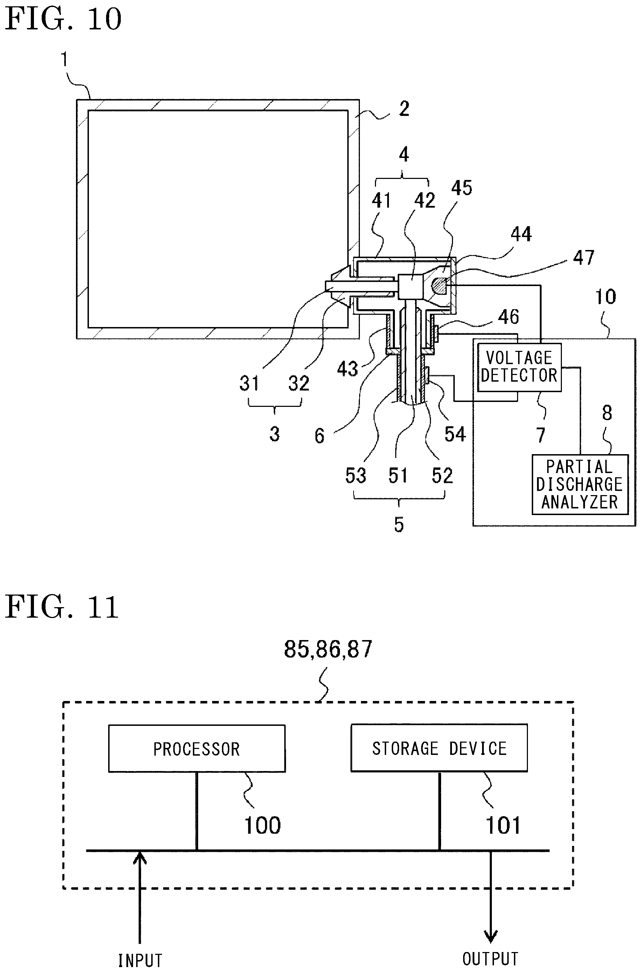

FIG. 10 is a configuration diagram of a partial discharge monitoring device for a gas insulated switchgear according to embodiment 3. Unlike in the gas insulated switchgear described in embodiment 1, an electrical field relaxation electrode 47 is provided in the insulated adapter 4. Ordinarily, the electrical field relaxation electrode 47 is electrically connected to the electrically-conductive cover 44. Furthermore, the electrical field relaxation electrode 47 is set to be at the ground potential via the electrically-conductive cover 44. Meanwhile, as shown in FIG. 10, in the gas insulated switchgear in the present embodiment, the electrical field relaxation electrode 47 is electrically disconnected from the electrically-conductive cover 44 and is set to be at a floating potential. The voltage detector 7 is connected also to the electrical field relaxation electrode 47 set to be at the floating potential and also measures the voltage of the electrical field relaxation electrode 47. The partial discharge monitoring device for the gas insulated switchgear according to the present embodiment has the same configuration as the configuration of the partial discharge monitoring device for the gas insulated switchgear described in embodiment 1, except that the voltage detector 7 is connected to the electrical field relaxation electrode 47 set to be at the floating potential.

The potential of the electrical field relaxation electrode 47 set to be at the floating potential is changed to a potential induced by the grid voltage. Thus, the phase of the grid voltage can be measured by measuring the voltage of the electrical field relaxation electrode 47. In the partial discharge monitoring device for the gas insulated switchgear according to embodiment 1, the phase of the grid voltage is measured by measuring the voltage based on the induced current that flows, as a result of induction by the grid voltage, between the insulated adapter ground terminal 46 and the insulated bus bar ground terminal 54. However, when the resistances of the outer-surface ground layer of insulated adapter 43 and the outer-surface ground layer of insulated bus bar 53 are high, the phase of the induced current might lag behind the phase of the actual grid voltage. As a result, a deviation between the phase of the pulse of the partial discharge and the phase of the grid voltage described in embodiment 1 might occur, whereby erroneous determination regarding the ϕ-q-n pattern might occur.

The phase of the voltage, of the electrical field relaxation electrode 47, induced by the grid voltage hardly deviates from the phase of the grid voltage. In the gas insulated switchgear in the present embodiment, the phase of the grid voltage is measured by measuring the voltage, of the electrical field relaxation electrode 47, induced by the grid voltage. Therefore, in the partial discharge monitoring device for the gas insulated switchgear according to the present embodiment, there is little deviation between the phase of the pulse of the partial discharge and the phase of the grid voltage, whereby erroneous determination regarding the ϕ-q-n pattern can be prevented from occurring.

An example of hardware of each of the partial discharge occurrence determination unit 85, the partial discharge occurrence position determination unit 86, and the partial discharge occurrence factor determination unit 87 is, as shown in FIG. 11, composed of a processor 100 and a storage device 101. Although not shown, the storage device includes a volatile storage device such as a random access memory and a nonvolatile auxiliary storage device such as a flash memory. Alternatively, the storage device may include, as the auxiliary storage device, a hard disk instead of a flash memory. The processor 100 executes a program inputted from the storage device 101. In this case, the program is inputted from the auxiliary storage device via the volatile storage device to the processor 100. Furthermore, the processor 100 may output data such as a calculation result to the volatile storage device of the storage device 101 or may save the data via the volatile storage device into the auxiliary storage device.

Although the disclosure is described above in terms of various exemplary embodiments, it should be understood that the various features, aspects, and functionality described in one or more of the individual embodiments are not limited in their applicability to the particular embodiment with which they are described, but instead can be applied, alone or in various combinations to one or more of the embodiments of the disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

1 gas insulated switchgear
2 metal container
3 bushing
4 insulated adapter
5 insulated bus bar
6 insulating tube
7 voltage detector
8 partial discharge analyzer
10 partial discharge monitoring device
31 center conductor
32 insulating member
41 insulating container
42 contactor
43 outer-surface ground layer of insulated adapter
44 electrically-conductive cover
45 insulating member
46 insulated adapter ground terminal
47 electrical field relaxation electrode
51 center conductor
52 insulating member
53 outer-surface ground layer of insulated bus bar
54 insulated bus bar ground terminal
81 overvoltage protection circuit unit
82 amplification unit
83 filter unit
84 AD conversion unit
85 partial discharge occurrence determination unit
86 partial discharge occurrence position determination unit
87 partial discharge occurrence factor determination unit
100 processor
101 storage device

## Claims

1. A partial discharge monitoring device for a gas insulated switchgear connected to an external device via an insulated adapter and an insulated bus bar, the partial discharge monitoring device comprising:
a voltage detector which is connected between an outer-surface ground layer of the insulated adapter and an outer-surface ground layer of the insulated bus bar and which detects a voltage pulse due to a partial discharge and a phase of a grid voltage of the gas insulated switchgear; and
a partial discharge analyzer which performs partial discharge analysis on the basis of the voltage pulse detected by the voltage detector, wherein
the partial discharge analyzer includes
a partial discharge occurrence position determination unit which determines an occurrence position of the partial discharge on the basis of a polarity of the voltage pulse, and
a partial discharge occurrence factor determination unit which determines an occurrence factor of the partial discharge on the basis of a shape of a ϕ-q-n pattern of the partial discharge and the occurrence position of the partial discharge determined by the partial discharge occurrence position determination unit, where ϕ represents the phase of the grid voltage at a timing of occurrence of the voltage pulse, q represents an intensity of the voltage pulse, and n represents an occurrence frequency of the voltage pulse.

2. The partial discharge monitoring device for the gas insulated switchgear according to claim 1, wherein
the voltage detector is connected also to an electrical field relaxation electrode provided to the insulated adapter, and
the voltage detector detects the phase of the grid voltage via the electrical field relaxation electrode.

3. The partial discharge monitoring device for the gas insulated switchgear according to claim 1 or 2, wherein the partial discharge analyzer prestores therein shapes of ϕ-q-n patterns of a plurality of the partial discharges corresponding to respective occurrence factors of the plurality of the partial discharges.

4. The partial discharge monitoring device for the gas insulated switchgear according to claim 3, wherein the partial discharge occurrence factor determination unit recognizes, as an image shape, the shape of the ϕ-q-n pattern of the partial discharge and determines, by using an AI technology, whether or not the recognized image shape of the ϕ-q-n pattern of the partial discharge matches any of the prestored image shapes of the ϕ-q-n patterns of the plurality of the partial discharges.

5. The partial discharge monitoring device for the gas insulated switchgear according to any one of claims 1 to 4, wherein the voltage detector is implemented by an instrument current transformer.
